**Europäisches Patentamt**

**European Patent Office**

**Office européen des brevets**

(19)

(11) Publication number : **0 394 703 B1**

(12) # EUROPEAN PATENT SPECIFICATION

(45) Date of publication of patent specification :
**13.12.95 Bulletin 95/50**

(51) Int. Cl.⁶ : **H03F 3/45, H03F 1/32**

(21) Application number : **90106132.5**

(22) Date of filing : **30.03.90**

(54) **A circuit arrangement for enhancing the transconductance of a differential amplifier stage comprising MOS transistors**

(30) Priority : **28.04.89 IT 2031789**

(43) Date of publication of application :
**31.10.90 Bulletin 90/44**

(45) Publication of the grant of the patent :
**13.12.95 Bulletin 95/50**

(84) Designated Contracting States :
**DE FR GB NL SE**

(56) References cited :
**WO-A-89/03612
US-A- 3 678 404
US-A- 4 697 112
US-A- 4 720 685
JOURNAL OF THE AUDIO ENGINEERING
SOCIETY. vol. 29, no. 7/8, July 1981, NEW
YORK US pages 503 - 510; M. J. Hawksford:
"Distortion Correction Circuits for Audio Amplifiers"**

(73) Proprietor : **SGS-THOMSON
MICROELECTRONICS S.r.l.
Via C. Olivetti, 2
I-20041 Agrate Brianza (Milano) (IT)**

(72) Inventor : **Nicollini, Germano
Via A. Pavesi, 6
I-29100 Piacenza (IT)**
Inventor : **Castello, Rinaldo
Via C. Battisti, 48
I-20043 Arcore - Milano (IT)**

(74) Representative : **Perani, Aurelio et al
c/o JACOBACCI & PERANI S.p.A
Via Visconti di Modrone, 7
I-20122 Milano (IT)**

**EP 0 394 703 B1**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a circuit arrangement for enhancing the transconductance of a differential amplifier stage as defined in the preamble of claim 1.

As is well known, the differential stage or cell is one of the most widely used circuit components to be employed in a comprehensive range of analog circuit designs.

The structure of a bipolar technology differential stage comprises a pair of transistors which are connected together by way of their respective emitters through a circuit node which is also connected to a negative supply pole via a bias current source.

Also known are differential stages using the MOS technology, that is comprising a pair of field-effect transistors of the MOS type which have respective source electrodes connected together through the aforesaid circuit node.

Structures of the above-mentioned kind are described, for instance, in the publication: "Analysis and Design of Analog Integrated Circuits", Wiley & Sons, 1986.

It is a recognized fact that the electric signal input to a differential stage is represented by a voltage value Vin equal to the difference of the voltage values applied to the respective bases of the transistor pair, or to the respective gates of the MOS transistor pair.

The output electric signal is represented instead by a current Iout given by the difference between the values of the currents flowing through the respective collectors of the bipolar transistor pair, or the respective drains of the MOS transistor pair.

The basic parameter in defining the performance of a differential stage is represented by the so-called transconductance (gm), i.e. the ratio of the change in the output current to a change in the input voltage. This parameter shows to be dependent on the operating point of the stage.

The transconductance of a MOS transistor differential stage is, for given current supply and transistor dimensions, much lower than that of a differential stage with bipolar transistors.

In other words, in order to have the same transconductance from both of these different technologies, the MOS transistors should have large dimensions and a high current flowing therethrough.

Accordingly, in all those fields of application where high transconductance differential stages must be provided in the MOS technology, it becomes necessary to employ MOS transistors of huge dimensions and having very high currents flowing therethrough. Consequently, serious problems are brought about by the broad area occupied by such differential stages in the integrated circuits to which they are incorporated, as well as by the electric power dissipated thereby in large amounts. The shortcomings that accompany MOS technology differential stages have long been known, but the prior art has failed heretofore to provide any effective solutions to such problems.

From US-A-4720685 a differential stage is known which comprises two source-coupled input FET transistors and two output transistors. A linearizing stage includes two FET transistors having their sources commonly connected to a current generator, their gates connected to the drains of the input transistors and their drains cross-coupled to the drains of the output transistors.

From US-A-3678404 a differential amplifier is known which comprises a pair of input bipolar transistors. To avoid deviation from linearity, two additional transistors are connected in series with the emitters of the input transistors and have their bases cross-coupled to the emitters of the input transistors and their emitters connected together through an impedance and individually to a power terminal through respective current generators. The latter emitters are the circuit outputs.

Cross-coupled FET transistors are also known from Millman and Grabel "Microelectronics" 2nd edition, McGraw-Hill Inc. Singapore 1987, pages 164 and 356-359 and from EP-A-0 223 627 to form bistable circuits

The technical problem that underlies this invention is to provide a circuit arrangement which has such design and performance characteristics as to enhance the transconductance of a differential stage comprising MOS transistors, and at the same time keep the power dissipated by such stages low while occupying a reduced integrated circuit area.

This technical problem is solved according to the invention by a circuit arrangement as indicated and characterized in claim 1.

The features and advantages of the circuit arrangement according to the invention will be apparent from the following detailed description of an embodiment thereof, to be taken by way of illustration and not of limitation in conjunction with the accompanying drawings.

In the drawings:

Figure 1 is a diagrammatic representation of a differential stage incorporating the circuit arrangement of this invention;

Figure 2 is the equivalent wiring diagram of the differential stage shown in Figure 1; and

Figure 3 shows a wiring diagram of a modified embodiment of the circuit arrangement in Figure 1.

With reference to the drawing views, generally and schematically shown at 1 is a circuit arrangement for enhancing the transconductance of a differential amplifier stage 2 comprising a pair of enhancement n-channel MOS-type transistors M1 and M2.

These transistors M1 and M2 have respective source electrodes S1 and S2 substantially interconnected through the circuit arrangement 1, while being led to a circuit node indicated at N.

This node N is connected to a negative voltage supply pole -Ve via a bias current source or generator Is.

The drain electrodes D1 and D2 of the transistor pair M1, M2 are respectively connected to a voltage supply pole Vd via MOS transistors M7 and M8, each connected in a diode configuration.

Advantageously, in accordance with the invention, the arrangement 1 comprises a pair of active components M3 and M4, each formed by a MOS-type transistor.

Each active component is connected in the electric connection between every source electrode S1 and S2 and the node N. More specifically, the transistor M3 has its drain electrode D3 connected to the source electrode S1 of the transistor M1, whilst the second transistor M4 has its corresponding drain electrode D4 connected to the source electrode S2 of the other transistor M2 in the stage 2.

The respective source electrodes S3 and S4 of that second transistor pair M3, M4 are interconnected via the node N.

In addition, each of the transistors M3 and M4 has its corresponding gate electrode G3 and G4 cross-connected to the drain electrode D4 and D3 of the other transistor forming the pair.

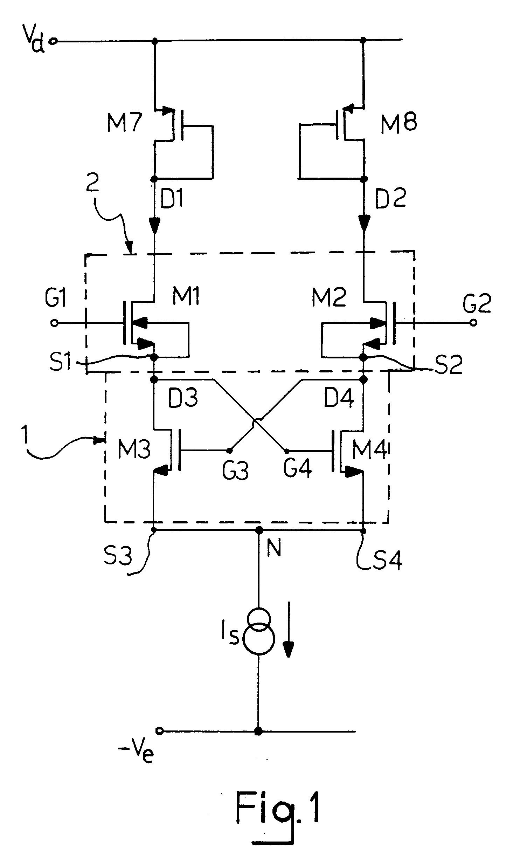

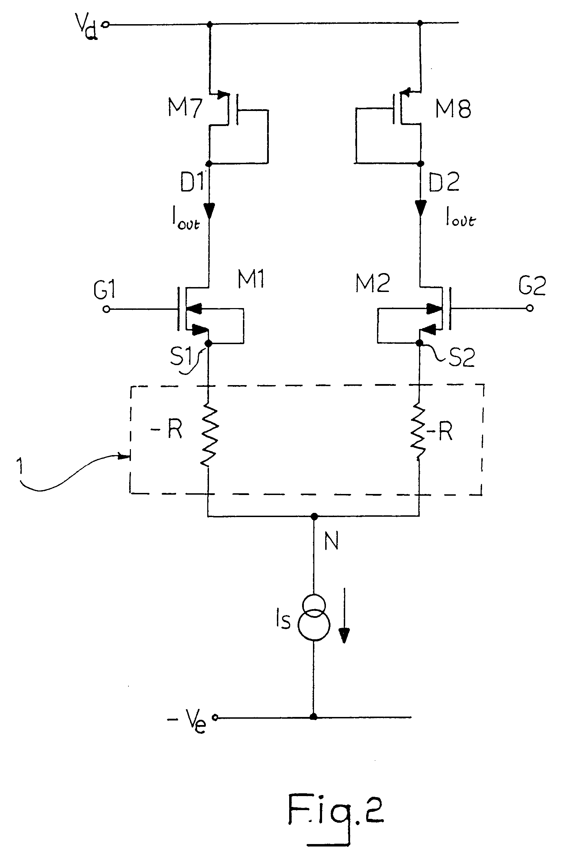

The active components M3 and M4 serve a characteristic function corresponding to that of a negative value resistor. In this respect, shown in Figure 2 is an equivalent electric wiring diagram of the inventive differential stage shown in Figure 1.

In that diagram, the active components M3 and M4 have been represented schematically with a negative value resistor R.

The value of the current Iout output by the differential stage 2 is given by the following relation,

$$Iout = gm1 * Vin/(1 - gm1 * R)$$

where, gm1 is the transconductance of the differential pair formed by transistors M1 and M2, R is the value of the equivalent resistance of each of the active components M3 and M4, and Vin is the value of the input voltage.

The resistance value R being negative, it follows that the circuit arrangement of this invention can greatly increase the value of the equivalent transconductance of the differential stage to which it has been incorporated.

More particularly, by applying the so-called low-signal method of analysis, it becomes possible to calculate the resistance, or rather, the DC impedance, of the inventive circuit arrangement, as seen from the source electrodes S1 and S2.

It may be shown that the value of that resistance R is equal to -1/gm3, where gm3 is the transconductance of transistor M3.

By substituting this resistive value in the previously specified relation, it may be shown that the amplification factor of the transconductance gm1 of differential stage 2 is tied to the ratio gm3/gm1. The value of this ratio can be selected with special accuracy in current production integrated circuits, and in this particular case, is set at 0.9.

The last-mentioned value has proved specially effective to provide a significant increase in the transconductance of differential stage 2, while avoiding triggering of objectionable oscillations in the circuit arrangement 1, which due to the cross-connected transistors M3 and M4, forms essentially a positive feedback loop for which a lower loop gain than unity must be ensured.

For the sake of completeness, it should be further noted that, in a preferred embodiment, the transistors M1, M2 and M3, M4 have the same channel length L, have a channel width W which is proportional among them by a constant K1, and have equal currents flowing therethrough because the gate currents of M3 and M4 are null.

In this way, it becomes possible to define in a specially accurate and industrially reproducible manner the value of the ratio gm3/gm1 to determine the transconductance element of the differential stage.

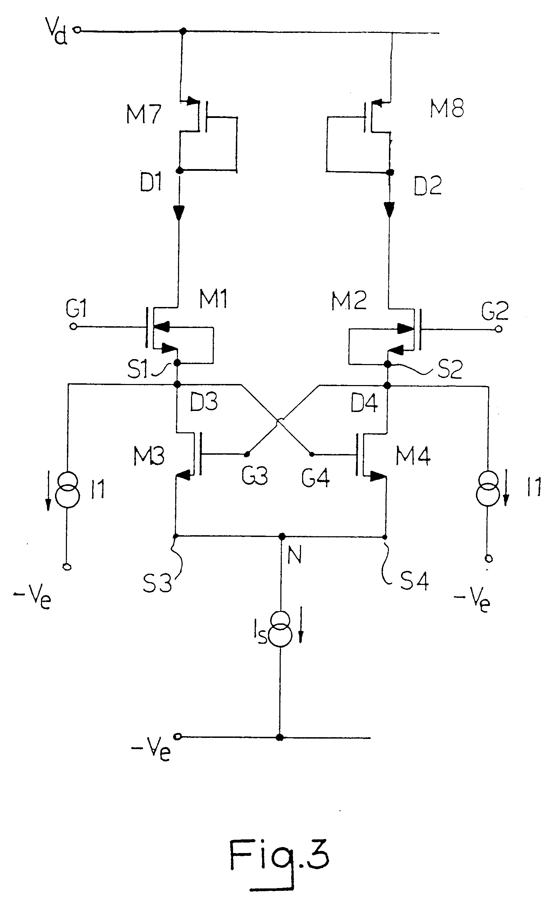

With particular reference to the example shown in Figure 3, a modified embodiment of the circuit arrangement according to the invention will be now described, wherein cooperating items and parts being similar in structure and operation to those of the previously-described embodiment are denoted by the same reference numerals and characters.

In Figure 3, the circuit arrangement 1 is shown to include a pair of identical current sources or generators 11. A first current source 11 has one end connected to the source electrode S1 of transistor M1 in the stage 2, and the other end connected to the supply pole -Ve.

Likewise, the second current source 11 has one end connected to the source electrode S2 of the second transistor M2 in the stage 2, and the other end connected to the aforesaid pole.

In this variant, the geometrical length L and width W dimensions of all the transistors M1, M2, M3 and M4 are the same among them, whilst the value of the current 11 generated by the aforesaid sources or generators is given by the following relation,

$$I1 = (K3 - 1) * Is$$

where, K3 is a constant.

The operation of the circuit arrangement according to this variant of the invention is basically the same as that of the previously described embodiment.

The circuit arrangement of this invention can be readily incorporated, using conventional techniques, to an integrated circuit also incorporating the differential stage of MOS transistors.

By implementing the inventive circuit arrangement with the MOS technology, a circuit can be obtained which is specially compact and has low electric power requirements.

This circuit arrangement solves, therefore, the technical problem by affording greatly increased transconductance of a differential stage including MOS transistors, while drawing a modest amount of electric power and occupying an unusually small area of the integrated circuit.

## Claims

1. A circuit arrangement for enhancing the transconductance (gm) of a differential amplifier stage (2) comprising a first pair of MOS-type transistors (M1, M2) having their source electrodes (S1, S2) connected to a circuit node (N), which is connected to a first power supply pole (-Ve) through a common current source (Is), their drain electrodes connected to a second power supply pole (Vd) through respective diode-connected MOS transistors (M7, M8) and their gate electrodes (G1, G2) connected to the input terminals of the stage, output means being provided to obtain an output signal from the currents flowing through said drain electrodes (D1, D2), characterized in that it comprises a second pair of MOS-type transistors (M3, M4) having their source electrodes (S3, S4) connected together and the gate electrode (G3, G4) of each transistor (M3, M4) connected to the drain electrode (D4, D3) of the other transistor (M4, M3) and in that the said connections of the source electrodes (S1, S2) of the transistors of the first pair (M1, M2) to said circuit node (N) is effected through respective drain-source paths of the transistors of said second pair (M3, M4), the said source electrodes (S3, S4) connected together being connected to said circuit node (N) directly.

2. A circuit arrangement according to claim 1, wherein the transistors of the first pair (M1, M2) have the same channel length (L) as the transistors of the second pair (M3, M4) and a channel width (W) proportional by a given constant (K1) to the channel width (W) of the transistors of the second pair (M3, M4), the bias currents flowing between the drain and source electrodes of the transistors of the first and second pair being the same.

3. A circuit arrangement according to claim 1, wherein the channel lengths (L) and channel widths (W) of the transistors of the first and second pair are respectively the same and wherein it comprises a pair of identical current sources (I1) connected between respective source electrodes (S1, S2) of the transistors of the first pair (M1, M2) and to said first power supply pole (-Ve), said current sources being so selected that their current (I1) has a predetermined value related to the current (Is) from said common current source.

## Patentansprüche

1. Eine Schaltungsanordnung zum Erhöhen der Transkonduktanz (gm) einer Differentialverstärkerstufe (2), die ein erstes Paar von MOS-Typ-Transistoren (M1, M2) aufweist, deren Source-Elektroden (S1, S2) mit einem Schaltungsknoten (N) verbunden sind, welcher durch eine gemeinsame Stromquelle (Is) mit einem ersten Leistungsversorgungspol (-V$_e$) verbunden ist, deren Drain-Elektroden über jeweilige diodenmäßig verschaltete MOS-Transistoren (M7, M8) mit einem zweiten Leistungsversorgungspol (Vd) verbunden sind, und deren Gate-Elektroden (G1, G2) mit den Eingangsanschlüssen der Stufe verbunden sind, wobei eine Ausgabeeinrichtung vorgesehen ist, um ein Ausgangssignal von den Strömen zu erhalten, die durch die Drain-Elektroden (D1, D2) fließen, dadurch gekennzeichnet, daß dieselbe ein zweites Paar von MOS-Typ-Transistoren (M3, M4) aufweist, deren Source-Elektroden (S3, S4) miteinander verbunden sind, wobei die Gate-Elektrode (G3, G4) jedes Transistors (M3, M4) mit der Drain-Elektrode (D4, D3) des anderen Transistors (M4, M3) verbunden ist, und daß die Verbindungen der Source-Elektroden (S1, S2) der Transistoren des ersten Paars (M1, M2) mit dem Schaltungsknoten (N) durch jeweilige Drain-Source-Wege der Transistoren des zweiten Paars (M3, M4) bewirkt werden, wobei die Source-Elektroden (S3, S4), die miteinander verbunden sind, direkt mit dem Schaltungsknoten (N) verbunden sind.

2. Eine Schaltungsanordnung gemäß Anspruch 1, bei der die Transistoren des ersten Paars (M1, M2) die gleiche Kanallänge (L) wie die Transistoren des zweiten Paars (M3, M4) und eine Kanalbreite (W) aufweisen, die durch eine gegebene Konstante (K1) proportional zu der Kanalbreite (W) der Transistoren des zweiten Paars (M3, M4) ist, wobei die Vorspannungsströme, die zwischen den Drain- und Source-Elektroden der Transistoren des ersten und des zweiten Paars fließen, die gleichen sind.

3. Eine Schaltungsanordnung gemäß Anspruch 1, bei der die Kanallängen (L) und Kanalbreiten (W) der Transistoren des ersten und des zweiten Paars jeweils die gleichen sind, wobei dieselbe ein Paar von identischen Stromquellen (I1) aufweist, die zwischen die jeweiligen Source-Elektroden (S1, S2) der Transistoren des ersten Paars (M1, M2) und den ersten Leistungsversorgungspol (-V$_e$) geschaltet sind, wobei die Stromquellen derart gewählt sind, daß ihr Strom (I1) einen vorbestimmten Wert bezüglich des Stroms (Is) von der gemeinsamen Stromquelle aufweist.

## Revendications

1. Montage de circuit pour augmenter la transconductance (gm) d'un étage amplificateur différentiel (2) comportant une première paire de transistors (M1, M2) du type MOS dont les électrodes de source (S1, S2) sont connectées à un noeud (N) de circuit, qui est connecté à un premier pôle (-Ve) d'alimentation en énergie par l'intermédiaire d'une source commune (Is) de courant, leurs électrodes de drain étant connectées à un second pôle (Vd) d'alimentation en énergie par l'intermédiaire de transistors respectifs (M7, M8) du type MOS, montés en diodes, et leurs électrodes de grille (G1, G2) étant connectées aux bornes d'entrée de l'étage, des moyens de sortie étant prévus pour l'obtention d'un signal de sortie à partir des courants circulant dans lesdites électrodes de drain (D1, D2), caractérisé en ce qu'il comporte une seconde paire de transistors (M3, M4) du type MOS dont les électrodes de source (S3, S4) sont connectées entre elles et dont l'électrode de grille (G3, G4) de chacun des transistors (M3, M4) est connectée à l'électrode de drain (D4, D3) de l'autre des transistors (M4, M3) et en ce que lesdites connexions des électrodes de source (S1, S2) des transistors de la première paire (M1, M2) audit noeud (N) de circuit sont réalisées par l'intermédiaire de trajets drain-source respectifs des transistors de ladite seconde paire (M3, M4), lesdites électrodes de source (S3, S4), connectées entre elles, étant connectées directement audit noeud (N) de circuit.

2. Montage de circuit selon la revendication 1, dans lequel les transistors de la première paire (M1, M2) ont la même longueur (L) de canal que les transistors de la seconde paire (M3, M4) et une largeur (w) de canal proportionnelle, d'une constante donnée (K1), à la largeur (W) de canal des transistors de la seconde paire (M3, M4), les courants de polarisation circulant entre les électrodes de drain et de source des transistors des première et seconde paires étant les mêmes.

3. Montage de circuit selon la revendication 1, dans lequel les longueurs (L) et les largeurs (W) des canaux des transistors des première et seconde paires sont, respectivement, les mêmes et dans lequel deux sources identiques (I1) de courant sont connectées entre des électrodes de source respectives (S1, S2) des transistors de la première paire (M1, M2) et audit premier pôle (-Ve) d'alimentation en énergie, lesdites sources de courant étant choisies de façon que leur courant (I1) ait une valeur prédéterminée liée au courant (Is) provenant de ladite source commune de courant.

Fig.1

Fig.2

Fig.3